# EUROPÄISCHE PATENTSCHRIFT

(11) **EP 0 338 316 B1**
(45) Veröffentlichungstag und Bekanntmachung des Hinweises auf die Patenterteilung: **19.06.1996**
(21) Anmeldenummer: 89105874.5
(22) Anmeldetag: 04.04.1989
(51) Int. Cl.: H03F 3/45

(54) **Bandpassverstärker**
Bandpass amplifier
Amplificateur à bande passante

(30) Priorität: 16.04.1988 DE 3812711
(43) Veröffentlichungstag der Anmeldung: 25.10.1989
(73) Patentinhaber: TEMIC TELEFUNKEN microelectronic GmbH, D-74072 Heilbronn (DE)
(72) Erfinder: Böhme, Rolf, Dr., D-7107 Bad Friedrichshall (DE)
(74) Vertreter: Maute, Hans-Jürgen, Dipl.-Ing.

(56) Entgegenhaltungen:
- EP-A- 0 104 950
- EP-A- 0 269 162
- IBM TECHNICAL DISCLOSURE BULLETIN. vol. 27, no. 3, August 1984, NEW YORK US Seiten 1645 - 1647; M.Bhansali,et al.: "Active Gain Cell For Linear Amplifiers"
- PATENT ABSTRACTS OF JAPAN vol. 11, no. 179 (E-514)(2626) 09 Juni 1987, & JP-A-6210907
- PATENT ABSTRACTS OF JAPAN vol. 10, no. 255 (E--433)(2311) 02 September 1986, & JP-A- 61 82512

## Beschreibung

Die Erfindung betrifft einen Bandpaßverstärker mit einer Differenzstufe aus zwei Transistoren, die von einer gemeinsamen Stromquelle gespeist werden.

Die Erfindung befaßt sich insbesondere mit einer elementaren Differenzverstärkerstufe für Zwischen- und Hochfrequenzverstärker, die insbesondere in bipolar integrierten Schaltungen Verwendung findet. Die Erfindung stellt einen Beitrag dar in der Überwindung zweier grundsätzlicher Schwierigkeiten bipolar integrierter HF-Verstärker, nämlich der unerwünschten Gleichgrößenverstärkung und der unerwünschten Breitbandigkeit solcher Verstärker.

Eine bekannte Lösung dieser Probleme ist in der niederländischen Patentschrift 8003197 aufgezeigt. Bei der bekannten Schaltung wird eine Differenzstufe aus einer Stromquelle und einem ersten und zweiten bipolaren Transistor mit einer kreuzgekoppelten Schaltung aus einem dritten und vierten bipolaren Transistor gleichen Leitfähigkeitstyps kombiniert. Der Kollektor des ersten Transistors ist mit dem Emitter des dritten Transistors und der Kollektor des zweiten Transistors ist mit dem Emitter des vierten Transistors verbunden, wobei die Verbindungsstellen gleichzeitig die Ausgänge der Schaltung darstellen. Die Kollektoren des dritten und vierten Transistors sind über einen ersten und zweiten Widerstand mit einer Versorgungsspannung verbunden. Außerdem ist der Kollektor des dritten Transistors über einen dritten Widerstand mit der Basis des vierten Transistors und der Kollektor des vierten Transistors über einen vierten Widerstand mit der Basis des dritten Transistors verbunden. Der erste und zweite Widerstand werden so dimensioniert, daß die Gleichspannungsverstärkung der Schaltung näherungsweise Null wird. Der dritte und vierte Widerstand dient der Einstellung der gewünschten Resonanzfrequenz.

Während diese Schaltung im Bereich hoher Frequenzen, z. B. bei ZF-Verstärkern für Fernsehempfänger, günstige Eigenschaften besitzt, wird ihre Anwendung bei ZF-Verstärkern für den Hörrundfunk schwieriger. Es ergaben sich verhältnismäßig große Werte des dritten und vierten Widerstandes und die Arbeitspunktstabilität leidet.

Der Erfindung liegt die Aufgabe zugrunde, eine Schaltung anzugeben, die auch bei tieferen Frequenzen anwendbar ist. Diese Aufgabe wird bei einem Bandpaßverstärker der eingangs erwähnten Art nach der Erfindung durch die kennzeichnenden Merkmale des Anspruchs 1 gelöst.

Die Erfindung wird im folgenden an Ausführungsbeispielen erläutert. In der zugehörigen Zeichnung zeigen:
- Fig. 1: Grundform der erfindungsgemäßen Lösung
- Fig. 2: Kompensation der Gleichgrößenverstärkung
- Fig. 3: Kapazitive Beschaltung zur Absenkung des Frequenzbereiches
- Fig. 4: Ausnutzung des Kapazitätsbelages integrierter Widerstände
- Fig. 5: Ausgangsseitige Kapazitätsbeschaltung
- Fig. 6: Erhöhung der Aussteuerfähigkeit

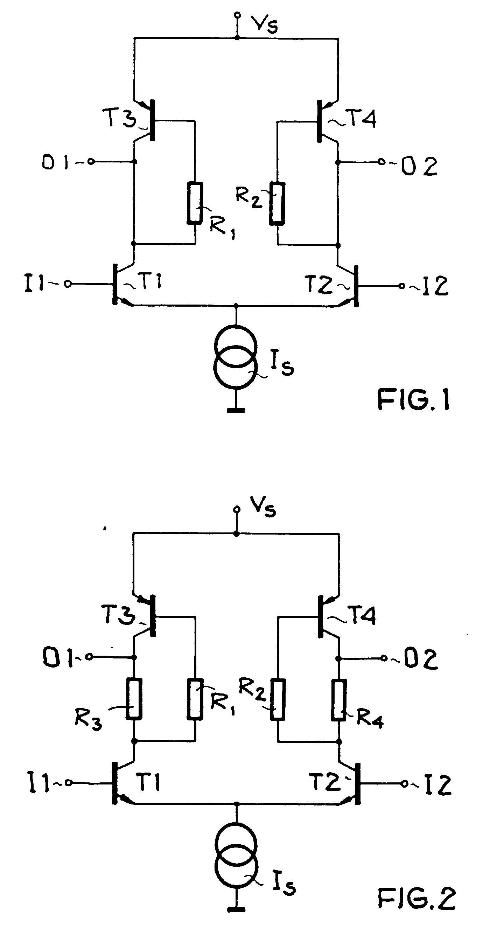

Die Fig. 1 zeigt die Erfindung in ihrer einfachsten Form. Sie geht aus von einer üblichen Differenzstufe aus den Transistoren T1, T2, deren Basisanschlüsse den Eingang I1, I2 der Schaltung bilden und deren Emitter mit einer Stromquelle Is verbunden sind. Der Kollektor des ersten Transistors T1 ist über einen Widerstand R1 mit der Basis eines dritten Transistors T3 verbunden. Ebenso ist der Kollektor des zweiten Transistors T2 über einen zweiten Widerstand R2 mit der Basis eines vierten Transistors T4 verbunden. Der Leitfähigkeitstyp des dritten und vierten Transistors ist zum Leitfähigkeitstyp des ersten und zweiten Transistors komplementär. Die Kollektoren des dritten Transistors T3 und des vierten Transistors T4 bilden die Ausgänge der Schaltung. Die Ausgänge der Schaltung sind mit den Kollektoren des ersten bzw. zweiten Transistors direkt oder nach Fig. 2 über einen dritten bzw. vierten Widerstand R3, R4 verbunden.

In einer bevorzugten Ausführungsform sind die Transistoren T1, T2 der Differenzstufe vertikale npn-Transistoren mit hoher Arbeitsgeschwindigkeit und die Transistoren T3, T4 laterale pnp-Transistoren mit wesentlich niedrigerer Arbeitsgeschwindigkeit. Zur Beschreibung der Funktionsweise sei angenommen, daß bei tiefen Frequenzen die Widerstände R1, R2 klein gegenüber dem Eingangswiderstand der zugehörigen Transistoren T3, T4 sind. Dann wirken die Transistoren T3, T4 gegenüber den Arbeitsströmen der Transistoren der Differenzstufe wie einfache Dioden. Die Verstärkung der in Fig. 1 dargestellten Schaltung hat dann etwa den Wert eins. Soweit diese geringe Verstärkung noch stört, wird durch die in Fig. 2 eingeführten Widerstände R3, R4 eine Kompensation auf Null möglich, indem diese Widerstände gleich oder annähernd gleich dem Kehrwert der Steilheit der Transistoren T1, T2 der Differenzstufe gemacht werden. Mit wachsender Frequenz sinkt der Eingangswiderstand der Transistoren T3, T4 ab und es bildet sich eine Spannungsteilung über den Widerstand R1 bzw. den Widerstand R2 und den Eingangswiderständen der zugehörigen Transistoren T3, T4 aus. Diese Spannungsteilung hat den Charakter eines Tiefpasses. Die abfallende Eingangsspannung ist mit einer anwachsenden, induktiven Impedanz des Kollektoranschlusses verknüpft. Dies führt zu einer mit der Frequenz zunehmenden Verstärkung. Im Grenzfall ist die Basis-Eingangsspannung der Transistoren T3, T4 auf Null abgesunken und die Verstärkung der Differenzstufe wird allein durch die Steilheit ihrer Transistoren und die Widerstände R1, R2 bestimmt. Dieser Grenzfall kann allerdings nicht ganz erreicht werden, weil außer den Widerständen auch parasitäre Kapazitäten vorhanden sind und weil das Verhältnis der Arbeitsgeschwindigkeiten der beiden Transistortypen nicht beliebig groß sein kann. Somit kommt es bei weiter steigender Frequenz zum Abfall der Verstärkung und insgesamt zum Verhalten eines nicht sehr selektiven Bandpasses.

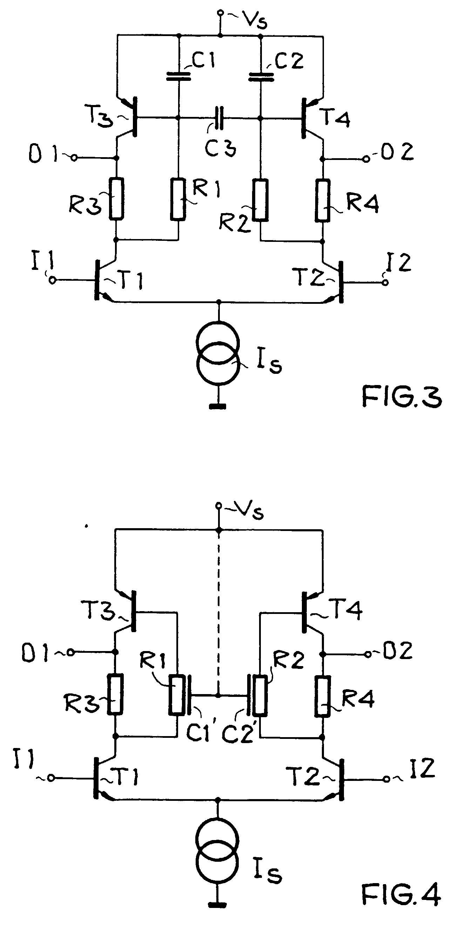

Die induktive Komponente der Impedanz der Transistoren T3, T4 wird erhöht und damit die untere Grenzfrequenz abgesenkt, wenn der Basis-Anschluß kapazitiv belastet wird. Dazu zeigt Fig. 3 zwei Möglichkeiten. Die eine Möglichkeit besteht darin, je einen Kondensator C1, C2 an je eine Basis der Transistoren T3, T4 anzuschließen und sie mit einer Bezugselektrode, der Versorgungsspannung Vs oder einem Masseanschluß, zu verbinden. Da laterale Transistoren naturgemäß bereits eine ausgeprägte Kapazität zwischen Basis und Substrat besitzen, können diese Kapazitäten auch durch eine Vergrößerung der Basiszone erreicht werden. Schließlich ist es möglich, einen potentialfreien Kondensator C5 an die Basen der Transistoren T3, T4 anzuschließen, wobei der gleiche Effekt mit der Hälfte einer Einzelkapazität C1, C2 erreicht wird.

Eine weitere Variante, die der bipolaren Integrationstechnologie besonders angepaßt ist, ist die Ausnutzung des Kapazitätsbelages der Widerstände R1, R2, wie in Fig. 4 gezeigt ist. Dadurch wird der Widerstand zwischen Kollektor und Basis der Transistoren T3 und T4 zu einem frequenzabhängigen Zwei-Tor mit Tiefpaß-Charakteristik, der die Tiefpaß-Wirkung der Eingangskapazität der Transistoren T3, T4 unterstützt. Da mit diesen Elementen eine Phasendrehung über 90° hinaus möglich ist, können auch schmalbandige Bandpässe implementiert werden.

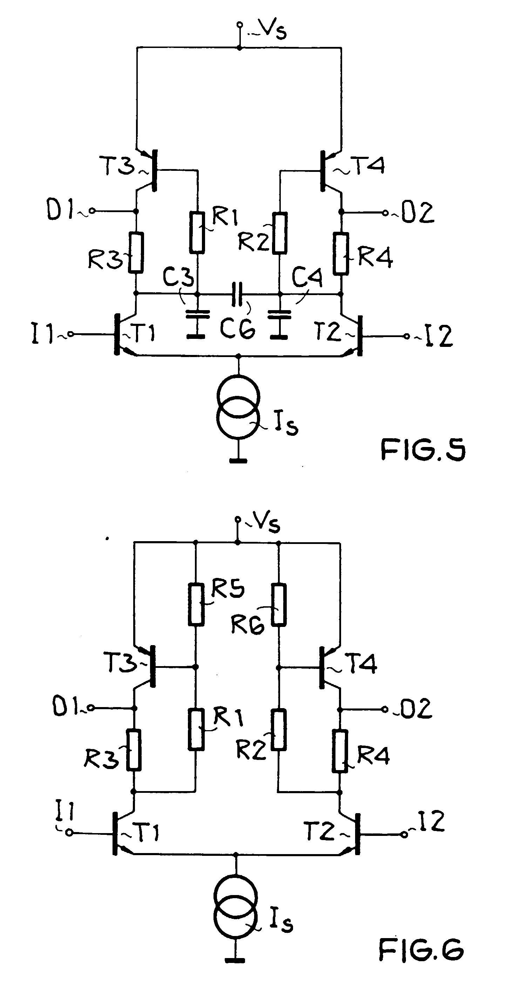

Faßt man die aus den Transistoren T3 oder T4 und den zugehörigen Widerständen und gegebenenfalls Kapazitäten gebildeten Schaltungsteile als Arbeitswiderstände der Transistoren T1, T2 der Differenzstufe auf, so sind diese Arbeitswiderstände frequenzabhängig, wobei die Frequenzabhängigkeit einer mit Widerständen beschalteten Induktivität entspricht. Diese Eigenschaft kann durch Zuschaltung von Kapazitäten C3, C4 an den Ausgängen 01, 02 der Schaltung zur Erzeugung niedrigerer Resonanzfrequenzen und schmalerer Bandbreiten benutzt werden. Da die Werte der Kompensationswiderstände R3, R4, falls welche vorgesehen sind, verhältnismäßig klein sind, kann die Zuschaltung ebensogut an den Kollektoren des ersten und zweiten Transistors erfolgen, wie in Fig. 5 dargestellt. Statt zweier Einzelkapazitäten C3, C4, die zu einem Referenzpunkt geschaltet sind, kann auch eine Einzelkapazität C6 vorgesehen sein, die direkt an die Ausgänge 01, 02 oder die Kollektoren der Transistoren T1, T2 angeschlossen ist.

In allen bisher betrachteten Schaltungen befindet sich das Potential des Ausgangs 01 bzw. 02 in der Nähe des Basispotentials des zugehörigen Transistors T3, T4. Dadurch ist die Aussteuerbarkeit auf verhältnismäßig kleine Werte beschränkt. Es gibt verschiedene Methoden, die Aussteuerbarkeit zu erhöhen. Z. B. kann, wie in Fig. 6 gezeigt, durch einen zusätzlichen Widerstand R5 bzw. R6, der an die Basis des dritten Transistors T3 bzw. der Basis des vierten Transistors T4 angeschlossen ist und der jeweils mit dem zugehörigen Emitter verbunden ist, ein zusätzlicher Spannungsabfall über den Widerständen R1, R2 erzeugt und damit der zulässige Spannungshub vergrößert werden.

## Patentansprüche

1. Bandpaßverstärker mit einer Differenzstufe aus zwei Transistoren (T1, T2), die von einer gemeinsamen Stromquelle (Is) gespeist werden, dadurch gekennzeichnet, daß der Kollektor des ersten Transistors (T1) über einen Widerstand (R1) mit der Basis eines zum ersten und zweiten Transistor komplementären dritten Transistors (T3) und der Kollektor des zweiten Transistors (T2) über einen Widerstand (R2) mit der Basis eines zum ersten und zweiten Transistor komplementären vierten Transistors (T4) verbunden sind, daß die Emitter des dritten Transistors (T3) und des vierten Transistors (T4) mit einer Versorgungsspannungsquelle (Vs) verbunden sind und daß die Kollektoren des dritten Transistors (T3) und des vierten Transistors (T4) die Ausgangsklemmen (01, 02) des Verstärkers bilden.

2. Bandpaßverstärker nach Anspruch 1, dadurch gekennzeichnet, daß die Kollektoren des ersten und zweiten Transistors (T1, T2) mit den Ausgangsklemmen (01, 02) verbunden sind.

3. Bandpaßverstärker nach Anspruch 1, dadurch gekennzeichnet, daß ein Widerstand (R3) zwischen dem Kollektor des ersten Transistors (T1) und dem ersten Ausgang (01) und ein Widerstand (R4) zwischen dem Kollektor des zweiten Transistors (T2) und dem zweiten Ausgang (02) geschaltet ist.

4. Bandpaßverstärker nach einem der Ansprüche 1 bis 3, dadurch gekennzeichnet, daß der dritte und vierte Transistor (T3, T4) Lateraltransistoren sind.

5. Bandpaßverstärker nach einem der Ansprüche 1 bis 4, dadurch gekennzeichnet, daß die Basen des dritten Transistors (T3) und des vierten Transistors (T4) mit je einer Kapazität gegen Masse oder gegen die Versorgungsspannung (Vs) beschaltet sind.

6. Bandpaßverstärker nach einem der Ansprüche 1 bis 5, dadurch gekennzeichnet, daß die Eigenkapazität der Basen des dritten Transistors (T3) und des vierten Transistors (T4) durch vergrößerte Abmessungen der Transistorstrukturen vergrößert ist.

7. Bandpaßverstärker nach einem der Ansprüche 1 bis 6, dadurch gekennzeichnet, daß eine Kapazität (C5) an die Basen des dritten Transistors (T3) und des vierten Transistors (T4) angeschlossen ist.

8. Bandpaßverstärker nach einem der Ansprüche 1 bis 7, dadurch gekennzeichnet, daß die Widerstände (R1 und R2) einen Kapazitätsbelag (C1′, C2′) gegenüber Masse oder einer Bezugselektrode aufweisen.

9. Bandpaßverstärker nach einem der Ansprüche 1 bis 8, dadurch gekennzeichnet, daß die Ausgänge (01, 02) des Verstärkers oder die Kollektoren des ersten Transistors (T1) und des zweiten Transistors (T2) mit je einer Kapazität (C3, C4) gegen Masse oder eine Bezugselektrode beschaltet sind.

10. Bandpaßverstärker nach einem der Ansprüche 1 bis 9, dadurch gekennzeichnet, daß eine Kapazität (C6) an die Ausgänge (01, 02) des Verstärkers oder an die Kollektoren des ersten und zweiten Transistors (T1, T2) angeschlossen ist.

11. Bandpaßverstärker nach einem der Ansprüche 1 bis 10, dadurch gekennzeichnet, daß zwischen die Basen des dritten und vierten Transistors (T3, T4) und die Versorgungsspannung (Vs) je ein Widerstand (R5, R6) geschaltet ist.

## Claims

1. A bandpass amplifier with a difference stage comprising two transistors (T1, T2) which are fed from a common current source (Is), characterised in that the collector of the first transistor (T1) is connected via a resistor (R1) to the base of a third transistor (T3) which is complementary to the first transistor and the second transistor, and the collector of the second transistor (T2) is connected via a resistor (R2) to the base of a fourth transistor (T4) which is complementary to the first transistor and the second transistor, that the emitters of the third transistor (T3) and of the fourth transistor (T4) are connected to a supply voltage source (Vs), and that the collectors of the third transistor (T3) and of the fourth transistor (T4) form the output terminals (01, 02) of the amplifier.

2. A bandpass amplifier as claimed in Claim 1, characterised in that the collectors of the first and second transistors (T1, T2) are connected to the output terminals (01, 02).

3. A bandpass amplifier as claimed in Claim 1, characterised in that a resistor (R3) is connected between the collector of the first transistor (T1) and the first output (01), and a resistor (R4) is connected between the collector of the second transistor (T2) and the second output (02).

4. A bandpass amplifier as claimed in one of Claims 1 to 3, characterised in that the third and fourth transistors (T3, T4) are lateral transistors.

5. A bandpass amplifier as claimed in one of Claims 1 to 4, characterised in that the bases of the third transistor (T3) and of the fourth transistor (T4) are in each case connected to a capacitor to earth or to the supply voltage (Vs).

6. A bandpass amplifier as claimed in one of Claims 1 to 5, characterised in that the self-capacitance of the bases of the third transistor (T3) and of the fourth transistor (T4) is increased by enlarged dimensions of the transistor structures.

7. A bandpass amplifier as claimed in one of Claims 1 to 6, characterised in that a capacitor (C5) is connected to the bases of the third transistor (T3) and the fourth transistor (T4).

8. A bandpass amplifier as claimed in one of Claims 1 to 7, characterised in that the resistors (R1 and R2) possess a distributed capacitance (C1', C2') to earth or to a reference electrode.

9. A bandpass amplifier as claimed in one of Claims 1 to 8, characterised in that the outputs (01, 02) of the amplifier or the collectors of the first transistor (T1) and of the second transistor (T2) are in each case connected to a capacitor (C3, C4) to earth or to a reference electrode.

10. A bandpass amplifier as claimed in one of Claims 1 to 9, characterised in that a capacitor (C6) is connected to the outputs (01, 02) of the amplifier or to the collectors of the first and second transistors (T1, T2).

11. A bandpass amplifier as claimed in one of Claims 1 to 10, characterised in that a resistor (R5, R6) is in each case connected between the bases of the third and fourth transistors (T3, T4) and the supply voltage (Vs).

## Revendications

1. Amplificateur passe-bande possédant un étage différentiel formé de deux transistors (T1, T2) alimentés par une source de courant (Is) commune, caractérisé en ce que le collecteur du premier transistor (T1) est relié à travers une résistance (R1) à la base d'un troisième transistor (T3) complémentaire aux premier et deuxième transistors, et le collecteur du deuxième transistor (T2) est relié à travers une résistance (R2) à la base d'un quatrième transistor (T4) complémentaire aux premier et deuxième transistors, que les émetteurs du troisième (T3) et du quatrième transistor (T4) sont reliés à une source de tension d'alimentation (Vs) et que les collecteurs du troisième (T3) et du quatrième transistor (T4) forment les bornes de sortie (01, 02) de l'amplificateur.

2. Amplificateur passe-bande selon la revendication 1, caractérisé en ce que les collecteurs des premier et deuxième transistors (T1, T2) sont reliés aux bornes de sortie (01, 02).

3. Amplificateur passe-bande selon la revendication 1, caractérisé en ce qu'une résistance (R3) est intercalée entre le collecteur du premier transistor (T1) et la première sortie (01) et une résistance (R4) est intercalée entre le collecteur du deuxième transistor (T2) et la seconde sortie (02).

4. Amplificateur passe-bande selon une des revendications 1 à 3, caractérisé en ce que les troisième et quatrième transistors (T3, T4) sont des transistors latéraux.

5. Amplificateur passe-bande selon une des revendications 1 à 4, caractérisé en ce que les bases du troisième (T3) et du quatrième transistor (T4) sont reliées chacune à travers une capacité à la masse ou à la tension d'alimentation (Vs).

6. Amplificateur passe-bande selon une des revendications 1 à 5, caractérisé en ce que la capacité propre des bases du troisième (T3) et du quatrième transistor (T4) est augmentée par l'agrandissement des dimensions des structures des transistors.

7. Amplificateur passe-bande selon une des revendications 1 à 6, caractérisé en ce qu'une capacité (C5) est connectée aux bases du troisième (T3) et du quatrième transistor (T4).

8. Amplificateur passe-bande selon une des revendications 1 à 7, caractérisé en ce que les résistances (R1 et R2) présentent une capacité linéique (C1', C2') vis-à-vis de la masse ou d'une électrode de référence.

9. Amplificateur passe-bande selon une des revendications 1 à 8, caractérisé en ce que les sorties (01, 02) de l'amplificateur ou les collecteurs du premier (T1) et du deuxième transistor (T2) sont connectés chacun à travers une capacité (C3, C4) à la masse ou une électrode de référence.

10. Amplificateur passe-bande selon une des revendications 1 à 9, caractérisé en ce qu'une capacité (C6) est connectée aux sorties (01, 02) de l'amplificateur ou aux collecteurs des premier et deuxième transistors (T1, T2).

11. Amplificateur passe-bande selon une des revendications 1 à 10, caractérisé en ce qu'une résistance (R5, R6) est intercalée chaque fois entre les bases des troisième et quatrième transistors (T3, T4) et la tension d'alimentation (Vs).
